# EUROPEAN PATENT APPLICATION

(11) **EP 4 513 883 A1**
(43) Date of publication of application: **26.02.2025**
(21) Application number: 23811118.1
(22) Date of filing: 25.05.2023
(51) Int. Cl.: H04N 23/50

(54) **CAMERA ASSEMBLY, MANUFACTURING METHOD FOR CAMERA ASSEMBLY, AND ELECTRONIC DEVICE**

(30) Priority: 27.05.2022 CN 202210593622
(71) Applicant: Huawei Technologies Co., Ltd., Shenzhen, Guangdong 518129 (CN)
(72) Inventor: YI, Yuan, Shenzhen, Guangdong 518129 (CN); TANG, Huijun, Shenzhen, Guangdong 518129 (CN); CHEN, Jinbang, Shenzhen, Guangdong 518129 (CN); QUAN, Teng, Shenzhen, Guangdong 518129 (CN); WEI, Jinqiang, Shenzhen, Guangdong 518129 (CN)
(74) Representative: MERH-IP Matias Erny Reichl Hoffmann Patentanwälte PartG mbB
(86) International application number: PCT/CN2023/096183
(87) International publication number: WO 2023/227048

(57) **Abstract**

This application provides a camera assembly, a camera assembly preparation method, and an electronic device, and relates to the field of electronic device technologies, to resolve a problem of a large size of a camera assembly. The camera assembly provided in this application includes a circuit board, a photosensitive chip, a package body, and a camera lens. The circuit board has a hollow portion. The photosensitive chip is electrically connected to the circuit board and is fastened in the hollow portion by using the package body. The package body has a first mounting surface. One end of the camera lens faces the photosensitive chip and is fixedly attached to the first mounting surface. In the camera assembly provided in this application, the hollow portion is provided in the circuit board, and the photosensitive chip is disposed in the hollow portion, which helps reduce a height size of the camera assembly. In addition, the camera lens is fastened to the circuit board by using the package body, which further helps reduce a width size of the camera assembly, helps implement a miniaturization and lightness and thinness design of the camera assembly, and can reduce space occupation of the camera assembly.

## Description

### CROSS-REFERENCE TO RELATED APPLICATIONS

This application claims priority to Chinese Patent Application No. 202210593622.4, filed with the China National Intellectual Property Administration on May 27, 2022 and entitled "CAMERA ASSEMBLY, CAMERA ASSEMBLY PREPARATION METHOD, AND ELECTRONIC DEVICE", which is incorporated herein by reference in its entirety.

### TECHNICAL FIELD

This application relates to the field of electronic device technologies, and in particular, to a camera assembly, a camera assembly preparation method, and an electronic device.

### BACKGROUND

With continuous development of technologies, a form of an electronic device gradually develops towards a direction of lightness and thinness or a high screen-to-body ratio. As an important component in the electronic device, a camera assembly can implement an image capturing function. For example, in a notebook computer, to implement an image shooting function, at least one camera assembly is usually configured. With lightness and thinness and a high screen-to-body ratio design of the notebook computer, a conventional camera assembly imposes a clear constraint on lightness and thinness and high screen-to-body ratio design of the notebook computer due to large space occupation.

For example, because the camera assembly is thick, a thickness size of the notebook computer is large. In addition, when a width size of the camera assembly is large, large occupied space is increased, which is not conducive to improving a screen-to-body ratio of a display.

### SUMMARY

This application provides a camera assembly that helps reduce space occupation, a camera assembly preparation method, and an electronic device.

According to a first aspect, this application provides a camera assembly, which may include a circuit board, a photosensitive chip, a package body, and a camera lens. Specifically, the circuit board has a hollow portion. The photosensitive chip is electrically connected to the circuit board, and is fastened in the hollow portion by using the package body. The package body has a first mounting surface. One end of the camera lens faces the photosensitive chip and is fixedly attached to the first mounting surface. In the camera assembly provided in this application, the hollow portion is provided in the circuit board, and the photosensitive chip is disposed in the hollow portion, which helps reduce a height size of the camera assembly. In addition, the camera lens is fastened to the circuit board by using the package body, which further helps reduce a width size of the camera assembly, helps implement a miniaturization and lightness and thinness design of the camera assembly, and can reduce space occupation of the camera assembly.

During specific disposition, the circuit board may be of a long strip structure. That is, a length size of the circuit board is greater than a width size of the circuit board. The width size of the circuit board may be the same as a width size of the camera lens, so that the width size of the camera assembly is reduced.

In an example, the camera assembly may further include a light filter. The package body may further have a second mounting surface, and the light filter may be fastened to the second mounting surface. Certainly, in some implementations, the package body may further include a light-filtering material, and the package body may cover a light-receiving surface of the photosensitive chip. That is, the package body may function as a light filter. Therefore, during actual application, disposing of the light filter may be omitted, which helps reduce a quantity of components of the camera assembly, and can reduce preparation difficulty and costs of the camera assembly.

In an example, a part of the package body may be located outside the hollow portion. The first mounting surface may be located on a surface that is of the package body and that faces away from the circuit board.

Alternatively, the second mounting surface may be located on a surface that is of the package body and that faces away from the circuit board.

During specific application, the surface facing away from the circuit board may be a step surface. For example, a distance between the first mounting surface and the circuit board may be greater than a distance between the second mounting surface and the circuit board. That is, the first mounting surface is farther away from the circuit board than the second mounting surface.

In addition, during actual application, the hollow portion may be a groove, or may be a through hole. That is, the hollow portion may penetrate a thickness of the circuit board, or may not penetrate a thickness of the circuit board.

When the hollow portion is a groove, a pad of the circuit board may be located on a bottom wall of the groove. After the photosensitive chip is disposed in the hollow portion, an electrical connection between the photosensitive chip and the circuit board may be implemented. Certainly, the pad may alternatively be located on a first board surface of the circuit board or in another position. Details are not described herein.

When the hollow portion is a through hole, the pad of the circuit board may be located on the first board surface. The photosensitive chip and the circuit board may be connected through a connection line. That is, one end of the connection line may be connected to the pad, and the other end of the connection line may be connected to the photosensitive chip.

In an example, the package body may alternatively package the connection line. That is, the connection line may be wrapped in the package body, so that the package body protects the connection line.

In an example, a sink may be further provided on the first board surface of the circuit board, the hollow portion may be located in the sink, and the pad of the circuit board may be located on an inner wall of the sink.

The sink is provided, and the pad is disposed on the inner wall of the sink, which helps reduce a height of the connection line, and can prevent the connection line from being scratched, so that safety of the connection line can be improved. In addition, this also helps reduce the height size of the camera assembly.

When the package body is specifically disposed, the package body may fill the hollow portion, to ensure connection strength between the photosensitive chip and the circuit board, and improve structural strength of the circuit board.

In another example, the camera assembly may further include a support board. The support board may be disposed on a second board surface (a surface facing away from the first board surface) of the circuit board, and is fastened to the circuit board. Disposing the support board can improve structural strength of the circuit board.

According to a second aspect, this application further provides a camera assembly preparation method. The method may include:
providing a circuit board assembly, where the circuit board assembly includes at least two circuit boards that are disposed in a flat manner in a first direction, and a connection rib exits between two adjacent circuit boards;
providing a hollow portion on a first board surface of the circuit board, where in the first direction, a projection of the hollow portion is within the connection rib;
disposing a photosensitive chip in the hollow portion, and electrically connecting the photosensitive chip to the circuit board;
packaging the photosensitive chip in the hollow portion by using a package body; and
removing the connection rib.

In the preparation method provided in this application, the connection rib is disposed between the circuit boards, which helps ensure connection strength between adjacent circuit boards. In addition, when the hollow portion is prepared, because an edge of the hollow portion has abundant circuit board materials, specific structural strength can be maintained.

During specific preparation, before the hollow portion is provided, a support board may be further disposed on a second board surface of the circuit board, to improve structural strength of the circuit board.

In addition, in a final camera assembly, the support board may be included, or the support board may be removed.

In addition, during preparation, a light filter may be fastened to the package body.

Alternatively, a camera lens may be connected to the package body, to avoid using a structure such as a support, which helps reduce a size of the camera assembly.

According to a third aspect, this application further provides an electronic device. The electronic device may include the foregoing camera assembly or a camera assembly obtained by using the foregoing preparation method. The electronic device may include a housing, and the camera assembly may be disposed in the housing. The electronic device may be specifically a notebook computer, a tablet computer, a television, a smartwatch, or the like. A specific type of the electronic device is not limited in this application. The camera assembly provided in this application facilitates a miniaturization and lightness and thinness design of the electronic device.

### BRIEF DESCRIPTION OF DRAWINGS

FIG. 1 is a diagram of a three-dimensional structure of a notebook computer according to an embodiment of this application;
FIG. 2 is a top view of a conventional camera assembly according to this application;
FIG. 3 is a sectional view in an A-A direction of FIG. 2;
FIG. 4 is a top view of a camera assembly according to an embodiment of this application;
FIG. 5 is a sectional view in a B-B direction of FIG. 4;
FIG. 6 is a diagram of a cross-sectional structure of a camera lens according to an embodiment of this application;
FIG. 7 is a partial top view of a camera assembly according to an embodiment of this application;
FIG. 8 is a sectional view in a C-C direction of FIG. 7;
FIG. 9 is a sectional view of a partial structure of another camera assembly according to an embodiment of this application;
FIG. 10 is a sectional view of a partial structure of another camera assembly according to an embodiment of this application;
FIG. 11 is a sectional view of a partial structure of another camera assembly according to an embodiment of this application;
FIG. 12 is a sectional view of a partial structure of another camera assembly according to an embodiment of this application;
FIG. 13 is a sectional view of a partial structure of another camera assembly according to an embodiment of this application;
FIG. 14 is a sectional view of a partial structure of another camera assembly according to an embodiment of this application;
FIG. 15 is a sectional view of a partial structure of another camera assembly according to an embodiment of this application;
FIG. 16 is a sectional view of a partial structure of another camera assembly according to an embodiment of this application;
FIG. 17 is a flowchart of a camera assembly preparation method according to an embodiment of this application;
FIG. 18 is a partial plane diagram of a circuit board assembly according to an embodiment of this application;
FIG. 19 is a partial plane diagram of a circuit board assembly provided with a hollow portion according to an embodiment of this application;
FIG. 20 is a sectional view of a partial structure of a camera assembly according to an embodiment of this application;
FIG. 21 is a sectional view of a partial structure of a camera assembly according to an embodiment of this application;
FIG. 22 is a partial plane diagram of a circuit board assembly disposed with an electrical element according to an embodiment of this application;
FIG. 23 is a diagram of a cross-sectional structure of a camera assembly according to an embodiment of this application; and
FIG. 24 is a diagram of a planar structure of a camera assembly according to an embodiment of this application.

### DESCRIPTION OF EMBODIMENTS

To make objectives, technical solutions, and advantages of this application clearer, the following further describes this application in detail with reference to the accompanying drawings.

To facilitate understanding of a camera assembly provided in embodiments of this application, an application scenario of the camera assembly is first described below.

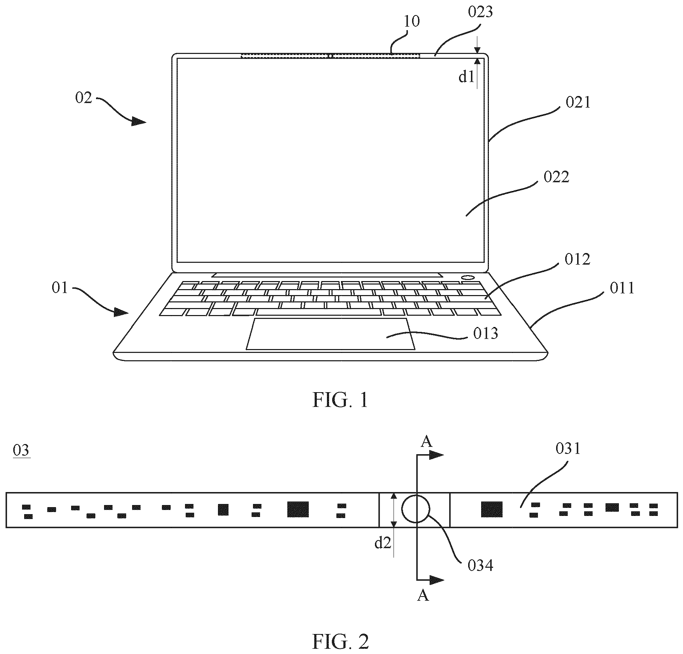

FIG. 1 is a diagram of a three-dimensional structure of a notebook computer according to an embodiment of this application. Specifically, the notebook computer may include a system end 01 and a display end 02. The system end 01 and the display end 02 may be connected by using a structure such as a hinge (not shown in the figure), so that the system end 01 and the display end 02 can be opened or closed relative to each other, to implement a foldable function of the notebook computer. The system end 01 may usually include a bottom housing 011, a keyboard 012, a touchpad 013, and components such as a mainboard, a processor, and a battery located in the bottom housing 011. The display end 02 may usually include components such as an upper cover 021 and a display 022.

A camera assembly 10 may be disposed at the display end 02. During specific disposition, the camera assembly 10 may be disposed in a frame 023 of the upper cover 021. The frame 023 may provide abundant mounting space for the camera assembly 10, and can well protect the camera assembly 10. In addition, when a user uses the notebook computer, the user may adjust a direction of the camera assembly 10 by adjusting an orientation of the display end 02, to obtain a required visual angle for image shooting. Therefore, flexible use experience is provided.

A plane on which the display 022 is located may also be referred to as a surface B, and a screen-to-body ratio of the display 022 is a ratio of a display region of the display 022 to the surface B. During actual application, to increase the screen-to-body ratio of the display 022, a value of a width size d1 of the frame 023 is usually reduced. The camera assembly 10 is disposed in the frame 023, and the width size d1 of the frame 023 is usually greater than a width size of the camera assembly 10. Alternatively, it may be understood that the width size of the camera assembly 10 imposes a constraint on the width size d1 of the frame 023, and affects further narrowing of the frame 023. Therefore, reducing the width size of the camera assembly 10 helps improve the screen-to-body ratio of the display 022.

Certainly, the camera assembly 10 provided in embodiments of this application may alternatively be used in an electronic device such as a tablet computer, a television, or a smartwatch, to implement an image shooting function. A specific application scenario of the camera assembly 10 is not limited in this application.

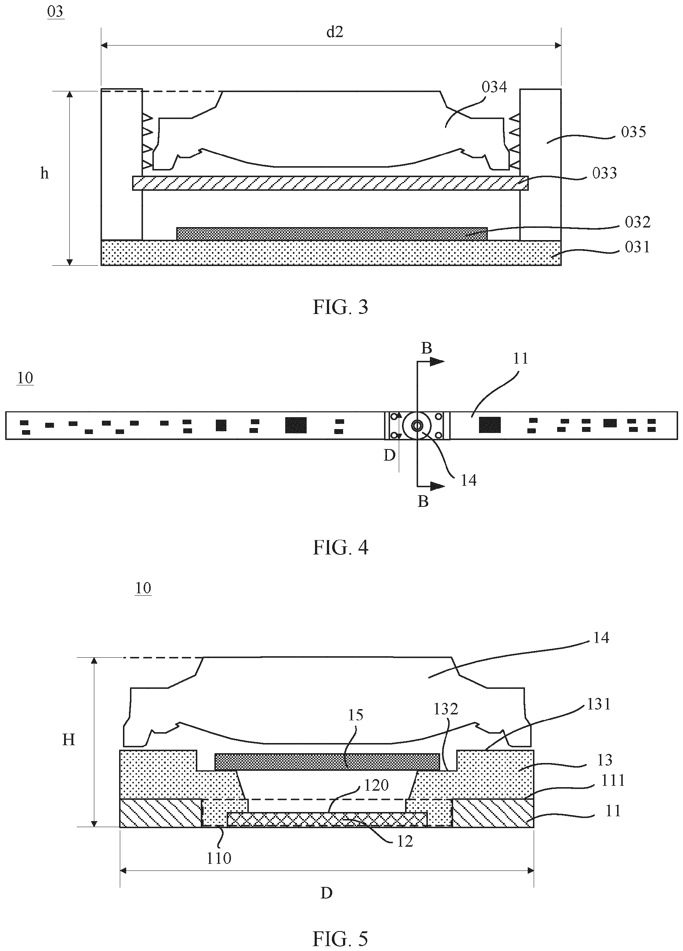

As shown in FIG. 2 and FIG. 3, FIG. 2 is a top view of a conventional camera assembly 03 according to this application, and FIG. 3 is a sectional view in an A-A direction of FIG. 2.

The camera assembly 03 may include a circuit board 031, a photosensitive chip 032, a light filter 033, and a camera lens 034 that are sequentially disposed in a stacked manner. The camera lens 034 is fastened to the circuit board 031 by using a support 035. A width size d2 of the support 035 is usually large, and is greater than a width size of the camera lens 034, which consequently increases a width size of the camera assembly 03. In addition, the support 035 is connected to the circuit board 031. Therefore, the circuit board 031 needs to have an abundant width size for mounting the support 035, which consequently increases the width size of the circuit board 031. Alternatively, it may be understood that, during actual application, the width size of the circuit board 031 is not less than the width size d2 of the support 035.

In addition, as shown in FIG. 3, because the photosensitive chip 032 and the circuit board 031 are disposed in a stacked manner, a height size h of the camera assembly 03 is usually large. In addition, the camera lens 034 and the light filter 033 are connected to the circuit board 031 by using the support 035, which further increases the height size h of the camera assembly 03.

Therefore, this application provides a camera assembly that helps implement a miniaturization and lightness and thinness design.

To make the objectives, technical solutions, and advantages of this application clearer, the following further describes this application in detail with reference to accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It should be further understood that, in the following embodiments of this application, "at least one" means one, two, or more.

Reference to "an embodiment" or the like described in this specification means that one or more embodiments of this application include a specific feature, structure, or characteristic described with reference to embodiments. Therefore, in this specification, statements, such as "in an embodiment", "in some implementations", and "in other implementations", that appear at different places do not necessarily refer to a same embodiment. Instead, the statements mean "one or more but not all of embodiments", unless otherwise specifically emphasized in another manner. Terms "include", "have", and variants of the terms all mean "including but not limited to", unless otherwise specifically emphasized in other ways.

As shown in FIG. 4 and FIG. 5, in an example provided in this application, the camera assembly 10 may include a circuit board 11, a photosensitive chip 12, a package body 13, and a camera lens 14. Specifically, the circuit board 11 has a first board surface 111 (an upper board surface in FIG. 5), and the first board surface 111 has a hollow portion 110 (a dashed box in FIG. 5). The photosensitive chip 12 is electrically connected to the circuit board 11, and is fastened in the hollow portion 110 by using the package body 13. The package body 13 has a first mounting surface 131. One end of the camera lens 14 faces the photosensitive chip 12 and is fixedly attached to the first mounting surface 131.

Specifically, in the camera assembly 10 provided in this application, the hollow portion 110 is provided in the circuit board 11, and the photosensitive chip 12 is disposed in the hollow portion 110, which helps reduce a height size H of the camera assembly 10. In addition, the camera lens 14 is fastened to the circuit board 11 by using the package body 13, which further reduces a width size D of the camera assembly 10.

For example, refer to FIG. 3 and FIG. 5. In FIG. 3, because the camera lens 034 is fastened to the circuit board 031 by using a support 035, the width sizes of the camera assembly 03 and the circuit board 031 are approximately equal to the width size d2 of the support 035, and are greater than the width size of the camera lens 034. As shown in FIG. 5, in the camera assembly 10 provided in embodiments of this application, because the support 035 in FIG. 3 is omitted, width sizes of the camera assembly 10 and the circuit board 11 are approximately equal to a width size of the camera lens 14. Therefore, a first mounting surface 131 is provided on the package body 13, so that a fixed connection between the camera lens 14 and the circuit board 11 can be implemented, and disposing of the support 035 can be omitted, which helps reduce the width size D of the camera assembly 10.

As shown in FIG. 3, it should be noted that, during actual application, because a distance between the camera lens 034 and the photosensitive chip 032 needs to be greater than a specified value, during actual application, the camera lens 034 needs to be fastened to the circuit board 031 by using the support 035, to ensure a minimum distance between the camera lens 034 and the photosensitive chip 032, and implement a fixed connection between the camera lens 034 and the circuit board 031.

As shown in FIG. 5, in the camera assembly 10 provided in this application, the first mounting surface 131 is provided on the package body 13, so that a fixed connection between the package body 13 and the camera lens 14 can be implemented. In addition, a distance between the first mounting surface 131 and the circuit board 11 (or the photosensitive chip 12) is properly set, so that a minimum distance between the camera lens 14 and the photosensitive chip 12 can be ensured.

When the package body 13 is disposed, a part of the package body 13 (for example, a part above the first board surface 111 in FIG. 5) may extend out of the hollow portion 110. The first mounting surface 131 may be located on a surface that is of the package body 13 and that faces away from the circuit board 11. A length, of the package body 13, extending out of the hollow portion 110 is controlled, so that the distance between the first mounting surface 131 and the circuit board 11 can be effectively controlled.

In summary, the package body 13 is disposed, so that a fixed connection between the photosensitive chip 12, the camera lens 14, and the circuit board 11 can be implemented, and position progress between the photosensitive chip 12 and the camera lens 14 can be effectively controlled, which helps ensure quality of the camera assembly 10.

In addition, as shown in FIG. 4 and FIG. 5, in an example provided in this application, the circuit board 11 is of a long strip shape. That is, the width size of the circuit board 11 is smaller, and a length size of the circuit board 11 is larger. The long strip-shaped circuit board 11 can provide a board surface of a larger area in a limited width size, and can be configured to provide a larger board layout area for an electrical element. In addition, during actual application, it is also convenient to use the camera assembly 10 in narrow space. It may be understood that, to reduce the width size D of the camera assembly 10 to a large extent, the width size of the circuit board 11 may be the same as the width size of the camera lens 14. It may be understood that the width sizes are the same, which means that the width sizes are roughly the same, and a size error may exist in engineering implementation.

In addition, after the package body 13 is filled in the hollow portion 110 of the circuit board 11, a gap between the photosensitive chip 12 and the circuit board 11 can be further filled, which helps improve structural strength of the circuit board 11 and ensures structural safety of the camera assembly 03.

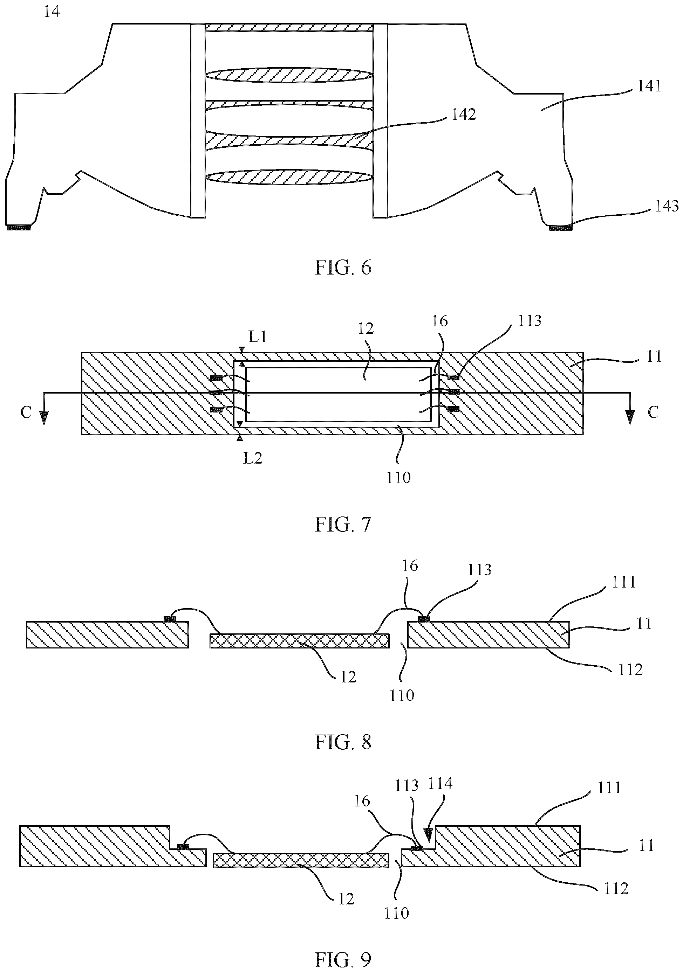

FIG. 6 is a brief diagram of a cross-sectional structure of a camera lens 14 according to an embodiment of this application. The camera lens 14 may include a lens cone 141 and a plurality of lenses 142 (five lenses are shown in FIG. 6) located in the lens cone 141. The plurality of lenses 142 may include a flat lens, a convex lens, a concave lens, and the like. A quantity, disposing positions, and shapes of the lenses 142 are not limited in this application. A main function of the lens cone 141 is to provide a mounting position for the lens 142, and form the plurality of lenses 142 into an integrated structure. The lens cone 141 may be of a tubular structure with openings at two ends. A sectional shape of the lens cone 141 may be a circle, a rectangle, an ellipse, an irregular shape, or the like. Light may enter the camera lens 14 from one end of the lens cone 141, and is emitted inward from the other end of the lens cone 141 after being processed by the lens 142 in the lens cone 141. Certainly, in another implementation, the camera lens 14 may alternatively include a structural part such as a protective housing or a shielding can. A specific structure of the camera lens 14 is not limited in this application.

As shown in FIG. 5 and FIG. 6, when the camera lens 14 is fastened to the first mounting surface 131 of the package body 13, one end of the lens cone 141 may be coated with glue 143, and then the end coated with the glue 143 is directly attached to the first mounting surface 131. After the glue 143 is solidified, a fixed connection between the camera lens 14 and the package body 13 may be implemented.

Certainly, in another example, the camera lens 14 may be fastened to the package body 13 through a welding technology or the like. A manner of connecting the camera lens 14 to the package body 13 is not limited in this application.

The circuit board 11 may be a printed circuit board (Printed Circuit Board, PCB), a flexible circuit board (Flexible Printed Circuit, FPC), or the like. In addition, the circuit board 11 may be a single-layer board or a multilayer board. A specific type of the circuit board 11 is not limited in this application.

The photosensitive chip 12 is a component for converting an optical image into an electrical signal. When light illuminates a light-receiving surface 120 of the photosensitive chip 12, an optical signal may be converted into an electrical signal. The light-receiving surface 120 may specifically include a charge-coupled device (Charge-coupled Device, CCD), a complementary metal oxide semiconductor (Complementary Metal Oxide Semiconductor, CMOS), and the like. During actual application, a specific type of the photosensitive chip 12 may be properly selected according to an actual requirement. This is not limited in this application.

In addition, as shown in FIG. 5, during actual application, the camera assembly 10 may further include a light filter 15. The light filter 15 may be an infrared light filter 15. That is, the light filter 15 may effectively filter infrared light in a specific band, to weaken infrared light transmitted to the photosensitive chip 12. Certainly, during specific application, a specific type of the light filter 15 is not limited in this application.

In addition, in embodiments provided in this application, the package body 13 further has a second mounting surface 132, and the light filter 15 may be fastened to the second mounting surface 132. During specific disposition, a surface that is of the light filter 15 and that faces the second mounting surface 132 may be coated with glue, and then the surface coated with the glue is directly attached to the second mounting surface 132. After the glue is solidified, a fixed connection between the camera lens 14 and the package body 13 may be implemented. Certainly, in another implementation, the light filter 15 may alternatively be fastened to the package body 13 through a welding technology or the like. A manner of connecting the light filter 15 to the package body 13 is not specifically limited in this application.

When the package body 13 is disposed, the part of the package body 13 (for example, the part above the first board surface 111 in FIG. 5) may extend out of the hollow portion 110. The second mounting surface 132 may be located on the surface that is of the package body 13 and that faces away from the circuit board 11.

In the example provided in FIG. 5, the surface that is of the package body 13 and that faces away from the circuit board 11 may be a step surface. For example, the distance between the first mounting surface 131 and the circuit board 11 may be greater than a distance between the second mounting surface 132 and the circuit board 11. That is, the first mounting surface 131 is farther away from the circuit board than the second mounting surface 132, so that the light filter 15 is disposed between the camera lens 14 and the photosensitive chip 12. During actual application, a height difference between the first mounting surface 131 and the second mounting surface 132 may be properly set according to an actual requirement (for example, a thickness size of the light filter 15). Details are not described herein.

When the photosensitive chip 12 is packaged, the first mounting surface 131 and the second mounting surface 132 may be prepared together according to an actual size requirement. Alternatively, the photosensitive chip 12 may be first packaged, and then the formed package body 13 is stacked, cut, or ground, to prepare the first mounting surface 131 and the second mounting surface 132. Alternatively, it may be understood that in this example provided in this application, the photosensitive chip 12, the camera lens 14, and the light filter 15 may all be fastened to the circuit board 11 by using the package body 13, which can effectively simplify a preparation procedure, to facilitate improvement of preparation efficiency. In addition, introduction of an additional support structure can be further avoided, which helps implement a lightweight and miniaturization design of the camera assembly 10.

A material of the package body 13 may be ceramic, silicon dioxide, polymer, or the like. During specific application, the material and a preparation technology of the package body 13 may be properly selected and adjusted according to an actual requirement. Details are not described herein.

During specific application, a specific structure of the hollow portion 110 may be diversified.

For example, as shown in FIG. 7 and FIG. 8, in an example provided in this application, the hollow portion 110 may be a through hole. That is, the hollow portion 110 penetrates the first board surface 111 and the second board surface 112 of the circuit board 11. The first board surface 111 and the second board surface 112 are board surfaces that are of the circuit board 11 and that face away from each other.

As shown in FIG. 7, during specific implementation, a distance L1 between one side edge of the hollow portion 110 and one side edge of the circuit board 11 may range from 0.2 mm to 2 mm. A distance L2 between another side edge of the hollow portion 110 and another side edge of the circuit board 11 may range from 0.2 mm to 2 mm. L1 and L2 may be equal, or may be unequal. Alternatively, in another implementation, L1 may be zero. Alternatively, L2 may be zero.

The photosensitive chip 12 and the circuit board 11 may be electrically connected through a connection line 16. Specifically, a pad 113 may be disposed on the first board surface 111 of the circuit board 11. One end of the connection line 16 (which may also be referred to as a gold wire) may be welded to the pad 113 of the circuit board 11, and the other end of the connection line 16 is welded to a pin of the photosensitive chip 12, to implement an electrical connection between the photosensitive chip 12 and the circuit board 11.

Alternatively, as shown in FIG. 9, in another example provided in this application, the first board surface 111 has a sink 114. The hollow portion 110 is located in the sink 114, and the pad 113 is located on an inner wall of the sink 114.

Specifically, in this example provided in this application, the hollow portion 110 is of a through-hole structure. The hollow portion 110 is provided on a bottom wall of the sink 114 and penetrates a thickness of the sink 114, and the pad 113 is located on the bottom wall of the sink 114. The sink 114 is provided, and the pad 113 is disposed on the bottom wall of the sink 114, which helps reduce a height of the connection line 16, and can prevent the connection line 16 from being scratched, so that safety of the connection line 16 can be improved. In addition, this also helps reduce the height size of the camera assembly 10.

During specific provision, a thickness size of the bottom wall of the sink 114 may be the same as or different from a thickness size of the photosensitive chip 12. This is not specifically limited in this application.

Alternatively, in another example, the pad 113 may be disposed on a side wall of the sink 114, which can also reduce the height of the gold wire. Details are not described herein again.

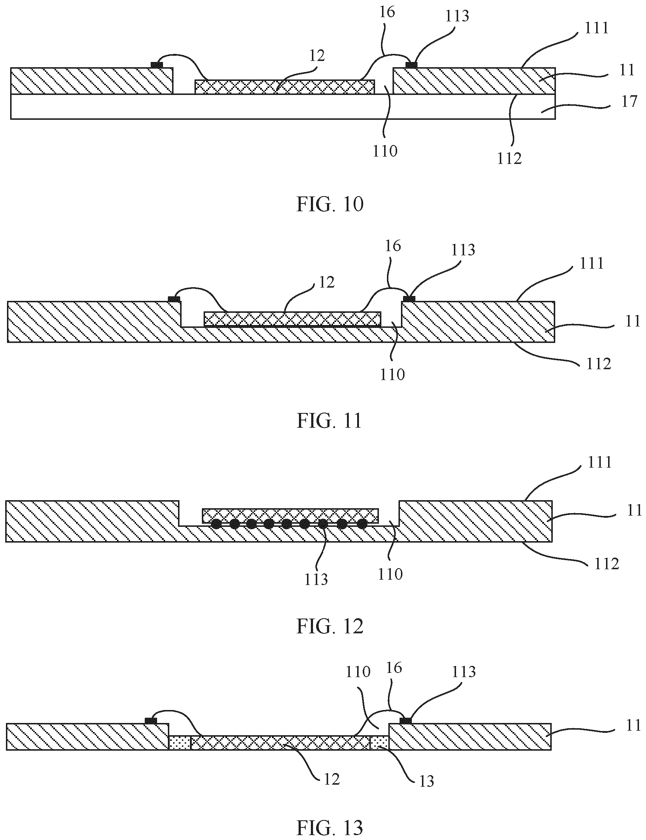

In addition, as shown in FIG. 10, in another example provided in this application, the camera assembly 10 may further include a support board 17. The support board 17 is disposed on the second board surface 112 of the circuit board 11, and is fastened to the circuit board 11. Disposing the support board 17 can improve structural strength of the circuit board 11. When the circuit board 11 is subject to an external force, the support board 17 can effectively disperse the external force, to reduce an acting force the circuit board 11 is subject to, and prevent the circuit board 11 from being bent, broken, or the like. The photosensitive chip 12 may alternatively be attached and fastened to the support board 17, so that connection stability between the photosensitive chip 12 and the circuit board 11 can be improved.

In addition, disposing the support board 17 further helps ensure position precision between the photosensitive chip 12 and the circuit board 11. For example, when the photosensitive chip 12 and the circuit board 11 are assembled, the support board 17 may be attached to the second board surface 112 of the circuit board 11. The photosensitive chip 12 is disposed in the hollow portion 110, and the photosensitive chip 12 is attached to the support board 17, so that a back surface (a surface facing away from the light-receiving surface 120) of the photosensitive chip 12 can be kept flush with the second board surface 112 of the substrate, to improve relative position precision between the photosensitive chip 12 and the circuit board 11.

During specific application, rigidity of the support board 17 may be greater than, equal to, or less than rigidity of the circuit board 11. In addition, the support board 17 may be of a board structure with a clear thickness, or may be of a film structure with a small thickness, or the like. A material and a specific size of the support board 17 are not limited in this application. In addition, in a specific preparation technology, before the hollow portion 110 is provided, the support board 17 may be disposed on the second board surface 112 of the circuit board 11, to prevent the circuit board 11 from being bent, broken, or the like. After preparation of the package body 13 is completed, the support board 17 may be removed, to prevent the support board 17 from increasing the height size of the camera assembly 10. Certainly, in another implementation, the support board 17 may alternatively not be removed, so that structural safety of the circuit board 11 can be ensured.

As shown in FIG. 11, in another example provided in this application, the hollow portion 110 may alternatively be a groove. That is, the hollow portion 110 does not penetrate the second board surface 112 of the circuit board 11.

During specific disposition, the pad 113 may be located on the first board surface 111 of the circuit board 11, and the photosensitive chip 12 and the circuit board 11 may be electrically connected through the connection line 16.

Alternatively, as shown in FIG. 12, the pad 113 may be located on a bottom wall of the groove. During preparation, a surface-mount technology or the like may be used to implement the electrical connection between the photosensitive chip 12 and the circuit board 11.

During specific provision, a depth size of the groove may be greater than a height size of the photosensitive chip 12. That is, the photosensitive chip 12 does not extend out of the groove.

Alternatively, a depth size of the groove may be less than a height size of the photosensitive chip 12. That is, the photosensitive chip 12 may extend out of the groove.

Certainly, in another implementation, a depth size of the groove may alternatively be approximately the same as a height size of the photosensitive chip 12. Details are not described herein.

When the package body 13 is disposed, a specific structure of the package body 13 may also be diversified.

As shown in FIG. 13, in an example provided in this application, the package body 13 may be filled between a side wall of the photosensitive chip 12 and a side wall of the hollow portion 110.

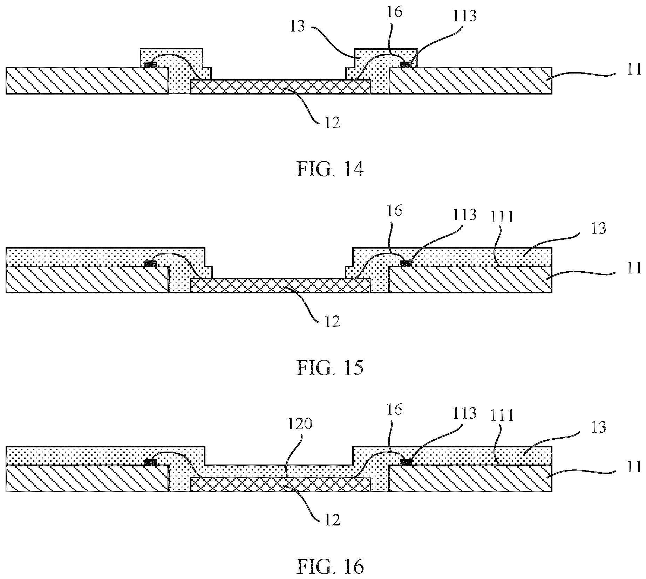

Alternatively, as shown in FIG. 14, the package body 13 may package the connection line 16. The connection line 16 may be wrapped in the package body 13, so that the package body 13 protects the connection line 16.

Alternatively, as shown in FIG. 15, the package body 13 may be located on the first board surface 111 of the circuit board 11.

Alternatively, as shown in FIG. 16, the package body 13 may cover the light-receiving surface 120 of the photosensitive chip 12, so that protection of the photosensitive chip 12 can be enhanced, and in addition, connection stability between the photosensitive chip 12 and the circuit board 11 can be improved.

During specific application, the package body 13 may be made of a material with good light transmission, to prevent the package body 13 from adversely affecting working performance of the photosensitive chip 12.

Alternatively, in some implementations, the package body 13 may have a light-filtering material. For example, the package body 13 may effectively filter light in a specific band. Alternatively, it may be understood that the package body 13 may function as a light filter. Therefore, during actual application, disposing of the light filter may be omitted, which helps reduce a quantity of components of the camera assembly 10, and can reduce preparation difficulty and costs of the camera assembly 10.

When the camera assembly 10 is prepared, a plurality of different technical procedures may be used.

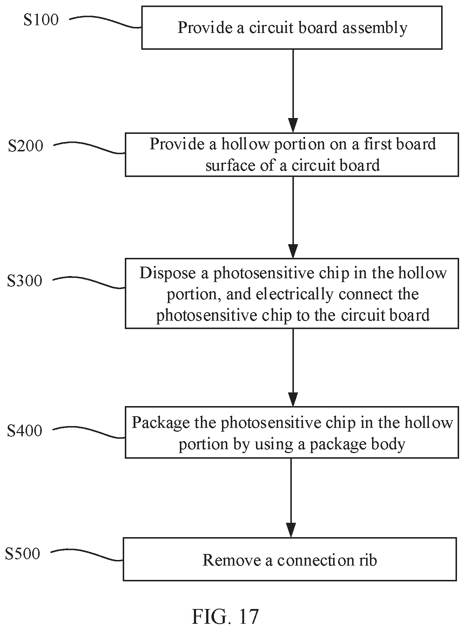

For example, as shown in FIG. 17, an embodiment of this application further provides a camera assembly preparation method. The method may include the following steps.

Step S100: Provide a circuit board assembly.

The circuit board assembly includes at least two circuit boards that are disposed in a flat manner in a first direction, and a connection rib exits between two adjacent circuit boards.

Step S200: Provide a hollow portion on a first board surface of the circuit board.

In the first direction, a projection of the hollow portion is within the connection rib.

Step S300: Dispose a photosensitive chip in the hollow portion, and electrically connect the photosensitive chip to the circuit board.

Step S400: Package the photosensitive chip in the hollow portion by using a package body.

Step S500: Remove the connection rib.

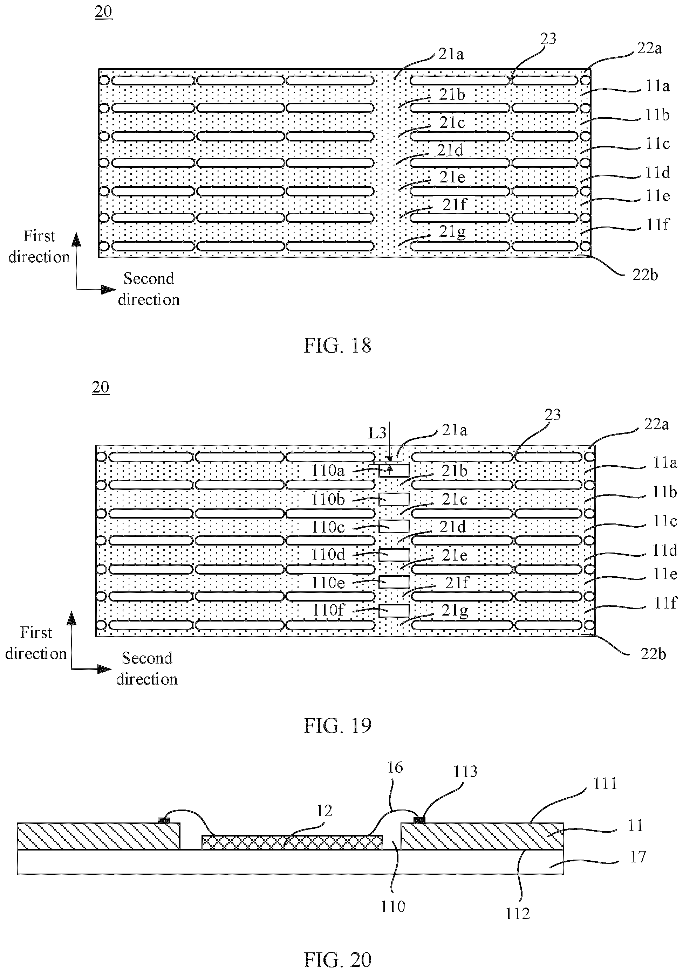

Specifically, refer to FIG. 18 to FIG. 24.

In an example provided in this application, the circuit board assembly 20 includes six circuit boards that are sequentially arranged in the first direction, which are a circuit board 11a, a circuit board 11b, a circuit board 11c, a circuit board 11d, a circuit board 11e, and a circuit board 11f. In addition, adjacent circuit boards are connected by using the connection rib, so that the plurality of circuit boards can be connected to form an integrated structure, to facilitate transportation or another subsequent preparation procedure. Specifically, the circuit board 11a and the circuit board 11b are connected by using a connection rib 21b, the circuit board 11b and the circuit board 11c are connected by using a connection rib 21c, the circuit board 11c and the circuit board 11d are connected by using a connection rib 21d, the circuit board 11d and the circuit board 11e are connected by using a connection rib 21e, and the circuit board 11e and the circuit board 11f are connected by using a connection rib 21f.

In addition, in the example provided in FIG. 18, in the first direction, a protection strip 22a and a protection strip 22b are disposed on two sides of the circuit board assembly 20. A connection rib 21a is disposed between the protection strip 22a and the circuit board 11a, and the protection strip 22b and the circuit board 11f are also connected by using a connection rib 21g. In an actual preparation procedure, a preparation device (for example, a mechanical arm) may act on the protection strip 22a or the protection strip 22b, to avoid contact with the circuit board, so that preparation quality of the circuit board can be ensured. Certainly, in another example, disposing of the protection strip may alternatively be omitted.

In addition, in the example in FIG. 18, a plurality of auxiliary ribs 23 are also shown. These ribs 23 help ensure connection stability between two adjacent circuit boards. During actual application, the rib 23 only needs to ensure connection stability between two adjacent circuit boards, or connection stability between the circuit board and the protection strip. That is, in a second direction, a size of the rib 23 may be less than a size of the connection rib (for example, the connection rib 21a), so that the rib 23 is cut subsequently. During actual application, a disposing quantity and positions of the ribs 23 may be properly set according to an actual requirement. This is not limited in this application.

It may be understood that, in the circuit board assembly 20, a gap between two adjacent circuit boards may be provided by a manufacturer of the circuit board. That is, the gap between two adjacent circuit boards may be prepared by the manufacturer of the circuit board, to reduce subsequent cutting time.

In addition, during actual application, the circuit board assembly 20 may alternatively include two, three, or more circuit boards. A specific quantity of circuit boards is not limited in this application.

Refer to FIG. 19. In a manner of laser cutting, cutting with a cutting tool, or the like, a hollow portion 110a may be provided in the circuit board 11a, a hollow portion 110b may be provided in the circuit board 11b, a hollow portion 110c may be provided in the circuit board 11c, a hollow portion 110d may be provided in the circuit board 11d, a hollow portion 110e may be provided in the circuit board 11e, and a hollow portion 110f may be provided in the circuit board 11f. In the first direction, a projection of the hollow portion is within the connection rib. Specifically, the hollow portion 110a and the connection rib 21a are used as examples. In the first direction, a projection of the hollow portion 110a is within the connection rib 21a. After preparation of the hollow portion 110a is completed, there are still abundant connection parts between the circuit board 11a and the connection rib 21a, so that an adverse situation such as a break of the circuit board 11a can be prevented. Alternatively, it may be understood that, in the first direction, if the projection of the hollow portion 110a does not fall within the connection rib 21, a width size L3 between a side edge of the hollow portion 110a and a side edge of the circuit board 11 is small (for example, less than 2 mm). Therefore, there is no abundant material to ensure structural strength of the circuit board 11a. When the circuit board assembly 20 is moved, an adverse situation such as a break is prone to occurring, which affects smooth performance of a subsequent preparation procedure and reduces preparation quality of a camera assembly.

It may be understood that, in an actual preparation process, a length of the connection rib (that is, a size of the connection rib in the second direction) may be properly set based on an actual size of the hollow portion. Details are not described herein.

In addition, as shown in FIG. 20, before a hollow portion 110 is provided, the method may further include: disposing a support board 17 on a second board surface 112 of a circuit board 11. A first board surface 111 faces away from the second board surface 112. Disposing the support board 17 can improve structural strength of the circuit board 11 (or the circuit board assembly 20). When the circuit board 11 is subject to an external force, the support board 17 can effectively disperse the external force, to reduce an acting force the circuit board 11 is subject to, and prevent the circuit board 11 from being bent, broken, or the like.

A photosensitive chip 12 and the circuit board 11 may be electrically connected through a connection line 16 (or a gold wire). For example, one end of the connection line 16 may be welded to a pad 113 of the circuit board 11, and the other end of the connection line 16 may be welded to a pin of the photosensitive chip 12, to implement an electrical connection between the photosensitive chip 12 and the circuit board 11. Certainly, in another preparation method, the photosensitive chip 12 and the circuit board 11 may alternatively be electrically connected by using a surface-mount technology or the like. A specific manner of implementing the electrical connection between the photosensitive chip 12 and the circuit board 11 is not limited in this application.

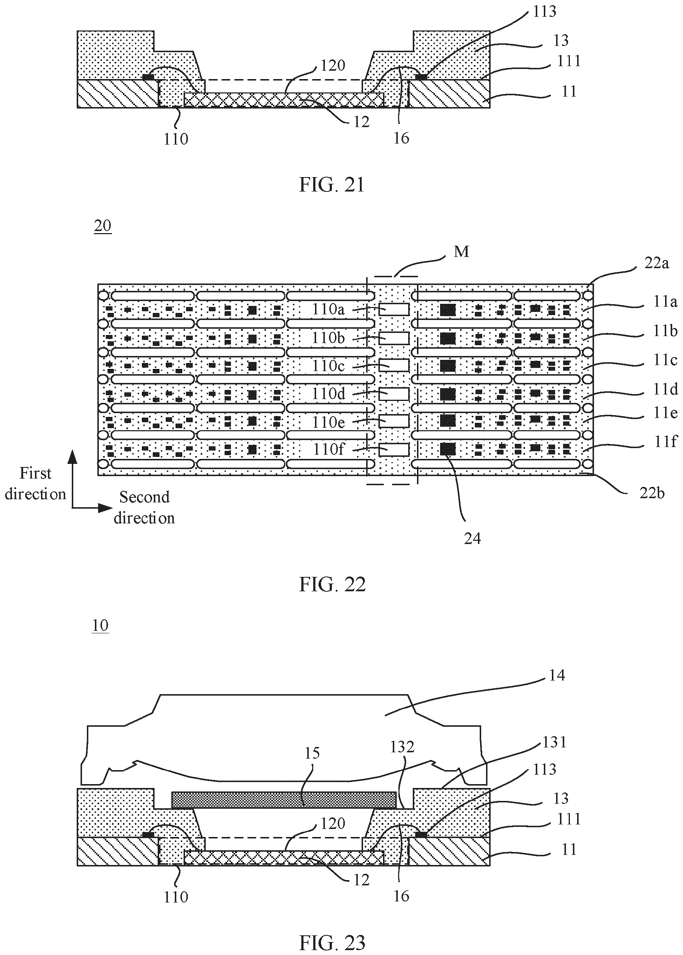

As shown in FIG. 21, when the photosensitive chip 12 is packaged, ceramic, silicon dioxide, polymer, or the like may be used as a packaging material. After the packaging material is solidified, the packaging material may be formed into a package body 13, and a fixed connection between the photosensitive chip 12 and the circuit board 11 is implemented.

As shown in FIG. 22, during packaging, the package body may cover a region M (a dashed box in FIG. 22) in which each hollow portion 110 is located, so that large-scale preparation and batch production are implemented. In addition, overall structural strength of the circuit board assembly 20 can be further improved by using the package body.

Certainly, in another preparation technology, a disposing position of the package body may be properly set according to an actual requirement. Details are not described herein.

In addition, as shown in FIG. 22, during actual application, an electrical element 24 such as a capacitor, a resistor, or an inductor may be further disposed in the circuit board 11. Therefore, in the actual preparation process, after the photosensitive chip 12 is packaged, the electrical element may be further disposed on the circuit board 11 by using a surface-mount technology or the like.

In addition, as shown in FIG. 23, during actual application, a camera assembly 10 may further include a light filter 15. After preparation of the package body 13 is completed, the light filter 15 may be further disposed on a second mounting surface 132 of the package body 13. It may be understood that, in an actual preparation technology, the package body 13 may alternatively be used to replace the light filter 15. For example, the packaging material may cover a light-receiving surface 120 of the photosensitive chip 12. During actual application, a specific component of the packaging material may be properly selected, so that the package body 13 has a light-filtering function.

In addition, in another preparation method, after preparation of the package body 13 is completed, a camera lens 14 may be further connected to the package body 13. During specific implementation, a first mounting surface 131 configured to mount the camera lens 14 may be provided in the package body 13. When the camera lens 14 is mounted, one end of the camera lens 14 may be coated with glue, and then the end coated with the glue is attached to the first mounting surface 131, to implement a fixed connection between the package body 13 and the camera lens 14.

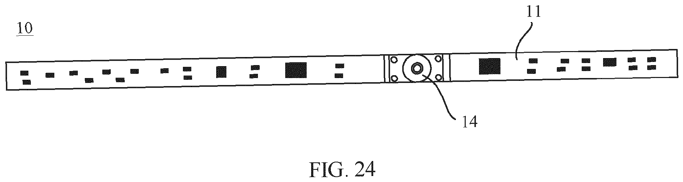

Refer to FIG. 22 and FIG. 24. Finally, the connection rib may be cut off in a manner of laser cutting, cutting with a cutting tool, or the like, to divide the plurality of circuit boards into independent units.

It may be understood that, because the package body 13 may fill the entire region M, when the connection rib is cut, the package body 13 may also be cut at the same time.

In addition, after the support board 17 is used, the support board 17 may be further removed, to prevent the support board 17 from increasing a height size of the camera assembly 10. Certainly, in another implementation, the support board 17 may alternatively not be removed, so that structural safety of the circuit board 11 can be ensured.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A camera assembly, comprising:
a circuit board having a hollow portion;
a photosensitive chip, disposed in the hollow portion and electrically connected to the circuit board;
a package body, configured to package the photosensitive chip in the hollow portion, wherein
the package body has a first mounting surface; and
a camera lens, wherein one end of the camera lens faces the photosensitive chip and is fixedly attached to the first mounting surface.

2. The camera assembly according to claim 1, further comprising a light filter, wherein
the package body has a second mounting surface, the light filter is located between the camera lens and the photosensitive chip, and the light filter is fixedly attached to the second mounting surface.

3. The camera assembly according to claim 2, wherein a part of the package body is located outside the hollow portion; and
the first mounting surface is located on a surface that is of the package body and that faces away from the circuit board.

4. The camera assembly according to claim 3, wherein the second mounting surface is located on the surface that is of the package body and that faces away from the circuit board; and
the first mounting surface is farther away from the circuit board than the second mounting surface.

5. The camera assembly according to any one of claims 1 to 4, wherein the hollow portion is a groove or a through hole.

6. The camera assembly according to claim 5, wherein the hollow portion is a groove, a pad is disposed on a bottom wall of the groove, and the photosensitive chip is electrically connected to the pad.

7. The camera assembly according to any one of claims 1 to 5, wherein the camera assembly further comprises a connection line;
the circuit board has a pad;
one end of the connection line is connected to the pad, and the other end of the connection line is connected to the photosensitive chip; and
the connection line is wrapped in the package body.

8. The camera assembly according to claim 7, wherein the circuit board has a first board surface, and the hollow portion and the pad are located on the first board surface.

9. The camera assembly according to claim 7, wherein the circuit board has a sink, the hollow portion is located in the sink, and the pad is located on an inner wall of the sink.

10. The camera assembly according to any one of claims 1 to 9, wherein the circuit board is of a long strip shape, and a width size of the camera lens is the same as a width size of the circuit board.

11. The camera assembly according to any one of claims 1 to 10, further comprising a support board, wherein
the circuit board has the first board surface and a second board surface, and the second board surface faces away from the first board surface; and
the hollow portion is located on the first board surface, and the support board is located on the second board surface.

12. A camera assembly preparation method, comprising:
providing a circuit board assembly, wherein the circuit board assembly comprises at least two circuit boards that are disposed in a flat manner in a first direction, and a connection rib exits between two adjacent circuit boards;
providing a hollow portion on a first board surface of the circuit board, wherein in the first direction, a projection of the hollow portion is within the connection rib;
disposing a photosensitive chip in the hollow portion, and electrically connecting the photosensitive chip to the circuit board;
packaging the photosensitive chip in the hollow portion by using a package body; and
removing the connection rib.

13. The preparation method according to claim 12, wherein before the providing a hollow portion on a first board surface of the circuit board, the method further comprises:
disposing a support board on a second board surface of the circuit board, wherein the first board surface faces away from the second board surface.

14. The preparation method according to claim 12, wherein after the packaging the photosensitive chip in the hollow portion by using a package body, the method further comprises:
removing the support board.

15. The preparation method according to any one of claims 12 to 14, further comprising:
providing a light filter, and fastening the light filter to the package body.

16. The preparation method according to any one of claims 12 to 15, further comprising:
providing a camera lens, and fastening the camera lens to the package body.

17. An electronic device, comprising the camera assembly according to any one of claims 1 to 11, or comprising a camera assembly obtained by using the preparation method according to any one of claims 12 to 16, wherein
the electronic device comprises a housing, and the camera assembly is disposed in the housing.
